(19) Europäisches Patentamt
European Patent Office
Office européen des brevets

(11) Publication number: 0 239 315 B1

# EUROPEAN PATENT SPECIFICATION

(45) Date of publication of patent specification: **19.06.91**  (51) Int. Cl.⁵: **H01L 23/31**

(21) Application number: **87302325.3**

(22) Date of filing: **18.03.87**

(54) Semiconductor device having an encapsulating package.

(30) Priority: **27.03.86 JP 67143/86**

(43) Date of publication of application:
**30.09.87 Bulletin 87/40**

(45) Publication of the grant of the patent:
**19.06.91 Bulletin 91/25**

(84) Designated Contracting States:
**DE FR GB**

(56) References cited:
**EP-A- 0 047 195**
**EP-A- 0 124 624**

**PATENT ABSTRACTS OF JAPAN, vol. 10, no. 58 (E-386)[2115], 7th March 1986; & JP-A-60 208 847**

**23RD ANNUAL PROCEEDINGS RELIABILITY PHYSICS 1985, 26th-28th March 1985, Orlando, Florida, pages 192-197, IEEE, New York, US; I. FUKUZAWA et al.: "Moisture resistance degradation of plastic LSIs by reflow soldering"**

(73) Proprietor: **Oki Electric Industry Company, Limited**
**7-12, Toranomon 1-chome Minato-ku Tokyo 105(JP)**

(72) Inventor: **Nambu, Seigo Oki Electric Industry Co., Ltd.**
**7-12, Toranomon 1-chome Minato-ku Tokyo(JP)**
Inventor: **Okuaki, Hiroshi Oki Electric Industry Co., Ltd.**
**7-12, Toranomon 1-chome Minato-ku Tokyo(JP)**
Inventor: **Takei, Shinji Oki Electric Industry Co., Ltd.**
**7-12, Toranomon 1-chome Minato-ku Tokyo(JP)**

(74) Representative: **SERJEANTS**
**25, The Crescent King Street Leicester, LE1 6RX(GB)**

**Description**

Field of Invention

The invention relates to a semiconductor device. and especially to a heat-resistant plastic semiconductor device having a flat package.

Background

As electronic devices are made to perform increasingly more functions and to process increasingly larger quantities of information at increasingly higher speeds, so-called flat IC's using flat plastic packages (FPP's), which are advantageous for high-density surface mounting, automated mounting, etc, on printed circuit boards, have been widely adopted for large-scale integrated circuits and other semiconductor devices.

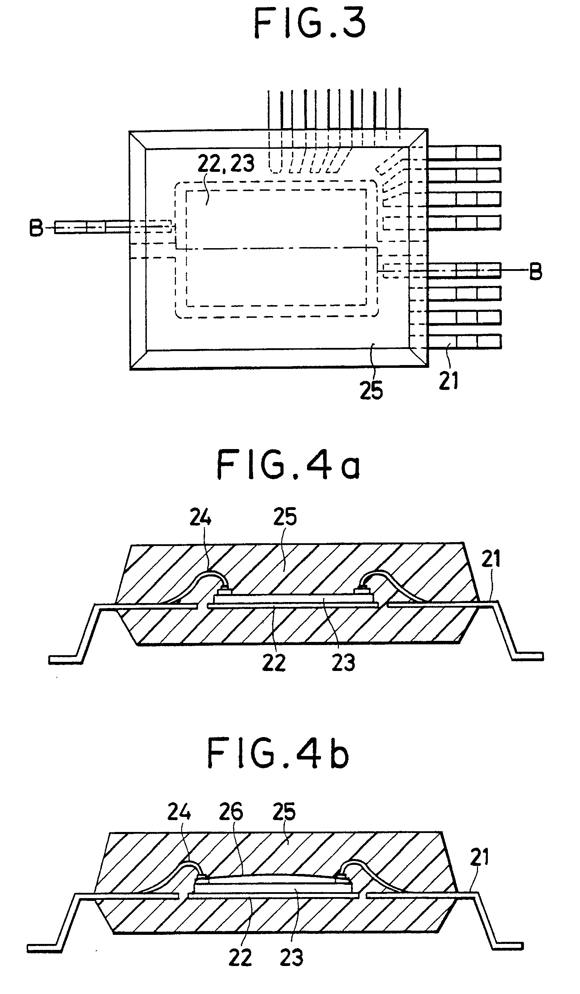

Figure 3 shows a flat IC, and Figure 4a and 4b show a cross section through the line B-B. Figures 4a shows the case in which a junction coating resin (JCR) is not used, while Figure 4b shows the case in which JCR is used. In the case of Figure 3 and Figure 4a, first the IC chip 23 is die-bonded on an island 22 supported by island supports, then the external leads 21 and the IC chip 23 are wire-bonded with gold wire 24, and the structure is sealed or encapsulated by a mould resin or moulding 25. In the case of Figure 4b, after the bonding of the gold wires 24, the surface of the IC chip 23 is coated with JCR 26 to improve the resistance to humidity.

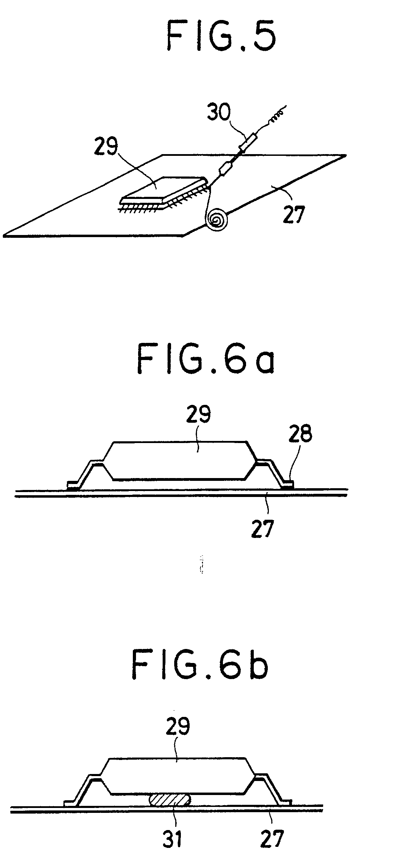

A conventional method of mounting a flat IC 29 having the above structure on a printed circuit board 27 is a partial-heating soldering method, in which only the leads 21 are heated by the soldering iron 30, as shown in Figure 5. Recently another method has often been used for items intended for mass production, in which the entire package is heated. Specifically, as shown in Figure 6a, solder paste is applied to the printed circuit board 27, the flat IC 29 is placed on the printed circuit board 27, then the heating is performed by such means as hot air or near- or far-infrared radiation. Another method, shown in Figure 6b, is to apply an adhesive 31 to the printed circuit board 27, place the flat IC 29 on the adhesive 31, thereby attaching it to the printed circuit board 27, and then dip the assembly in a solder bath.

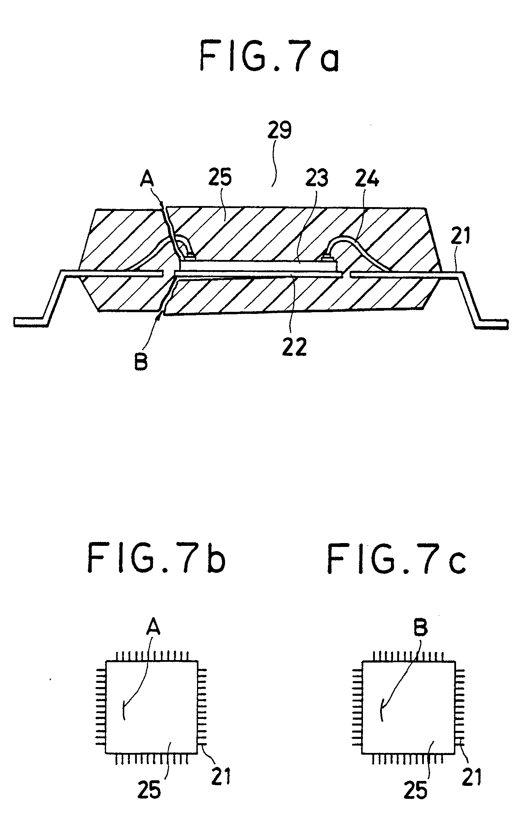

When the soldering method of heating the entire package is employed and the package is exposed to temperatures in excess of $200°$ C the package may crack. The Applicants believe that a major factor is that moisture which has penetrated the package while the device was left for about a week or more in ambient conditions of $23°$ C and 60% RH vaporizes, generating great stress, which acts from the inside of the package toward the outside. In addition, the strength of the moulding is reduced to nearly $0kg/cm^2$ to $0.1kg/cm^2$ for example. Since the IC chip is hermetically sealed, the vapour cannot easily escape to the outside. The result is that the flat IC, particularly one having a thin moulding, swells up like a balloon, eventually cracking the upper or lower surface of the moulding 25 which seriously degrades the visual appearance of the device as shown at A and B in Figure 7a. Figure 7a shows a cross-sectional view of a flat IC 29 with such a visual defect. Figure 7b shows a top view and Figure 7c showing a bottom view.

If such a flat IC 29 with a crack is used, the gold wire may break at the location of the crack. Moreover, moisture can easily enter the package at the crack, penetrate and reach the IC chip 23, and corrode the aluminium interconnections on its surface, eventually causing open circuits which prevent the IC from functioning.

It has been proposed in both Patent Abstracts of Japan Volume 10, No 58 (E-386) (2115), March 7th 1986 and 23rd Annual Proceedings Reliability Physics 1985, 26th-28th March 1985, Orlando, Florida, pages 192-197, IEEE, New York, United States, to alleviate the stresses generated as a result of vapour being sealed inside the IC package by providing a vent aperture in the package through which the vapour can escape.

Summary of the Invention

The invention provides a semi-conductor device having an IC Chip on one side of an island: external leads connected to the IC Chip: bonding wires for connecting the contacts of the IC Chip and the inner ends of the external leads: a package of moulded resin for encapsulating the IC Chip, the island, the bonding wires and the inner ends of the external leads: and a vent aperture extending through the package to the side of the island opposite to the IC Chip. The side of the island to which the aperture extends has a low adhesion layer that adheres only weakly to the resin of the package.

Adhesion at the interface between the resin of the package 35 and the low-adhesion layer is reduced.

When the device is soldered by a method involving heating the entire package, moisture absorbed inside the package can escape easily as vapour through the interface and the vent hole to the outside of the package. Internal stress resulting from water vapour pressure inside the package may be reduced and with it the incidence of cracking of the package.

Where the IC chip mounted on the package is covered by a chip coating capable at least of preventing the penetration of corrosive impurity ions from the resin, corrosion can be reduced. The chip coating may also serve to reduce thermal stress on the IC chip during the soldering process.

DRAWINGS:

Figure 1a is a bottom view showing a semiconductor device according to the invention;
Figure 1b is a cross section through line A-A in Figure 1a;
Figure 2a is a cross section showing a flash layer in a vent;
Figure 2b is a graph illustrating the maximum allowable thickness of the flash;
Figure 3 is a top view showing part of the prior art semiconductor device discussed previously;
Figure 4 shows a cross section through line B-B in Figure 3;
Figure 5 is a sketch showing the partial-heating method of attaching a flat IC;
Figure 6 is a sketch of the method in which the entire package is heated to attach a flat IC; and
Figure 7 is a sketch indicating defects of the prior art semiconductor device.

Description of the preferred examples of the invention

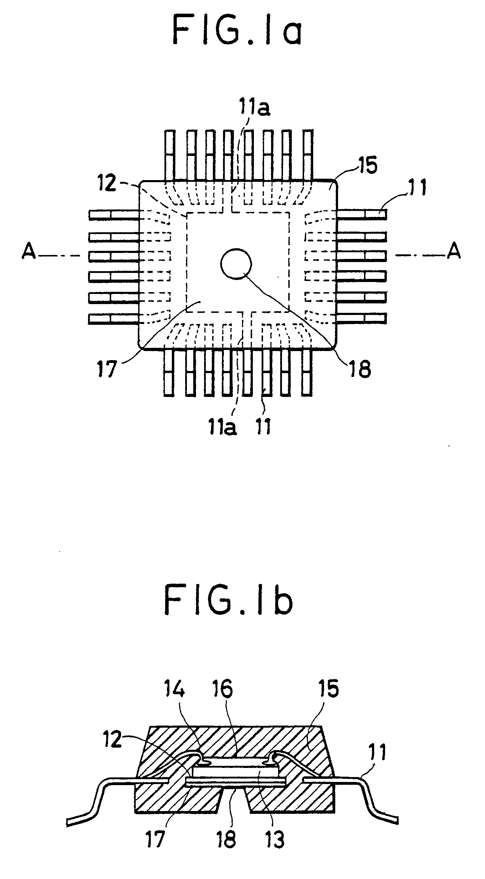

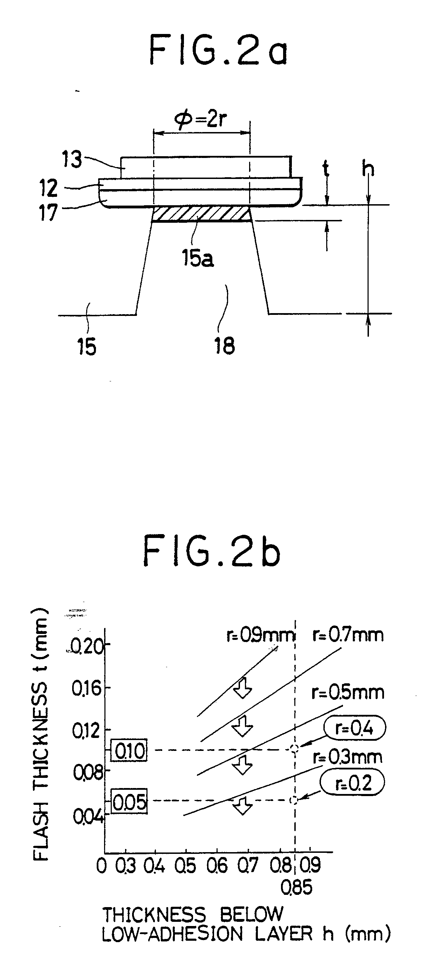

With reference to Figures 1 and 2 external leads 11 and an island 12 form a lead frame (in this case a 42-alloy lead frame by way of example). An IC chip 3 is die-bonded to the island 12. A thin metal wire 14 of gold is wire-bonded to connect a contact on the surface of the IC chip 13 to one of the external leads 11. Island supports 11a support the island 12.

A low-adhesion layer 17 of gold is plated to the undersurface of the island 12, that is to say on the opposite surface from that on which the IC chip 13 is mounted. Where the low-adhesion layer consists of gold plating, its surface is passive, so that it adheres only weakly to the mould resin of a moulding 15, which for example is of an epoxy resin.

A vent hole 18 extends from the bottom of the package to the low-adhesion layer 17. The vent hole may have the structure described on pages 73 to 78 of Oki Denki Kenkyu Kaihatsu 128 Vol. 52 No. 4, published 1st October 1985. For example, it can be given a circular shape by the forming die or mould.

Because of the low adhesion layer 17 and vent hole 18 on the underside of the package, water vapour is not trapped inside the package during soldering processes at temperatures exceeding 200°C but is vented through the interface between the low-adhesion layer 17 and the mould resin 15, and the vent hole 18 to the outside, which minimizes deformation of the package on heating. For protection from moisture, to which the interface between the low-adhesion layer 17 and moulding 15 affords a relatively easy entry, and for the purpose of reducing the stress which the moulding 15 exerts on the IC chip 13 due to thermal hysteresis, a chip coating 16 consisting of a silicone resin is applied to the surface of the IC chip 13, the silicone resin having a high-adhesion to the surface of the IC chip 13. The chip coating 16 also serves to prevent the penetration of corrosive impurity ions, such as chlorine (Cl) ions and sodium (Na) ions, from the resin of the moulding, to reduce corrosion of the contacts and interconnections of the surface of the IC chip. The chip coating 16 has the additional functions of preventing soft error due to alpha particles in the case where the semiconductor device is or contains a memory.

As shown in Figure 2a, there can be a thin layer of flash 15a between the low-adhesion layer 17 and the vent hole 18 produced during moulding of the resin. In this drawing r denotes the radius of the vent hole, h denotes the thickness of the resin 15 below the low-adhesion layer, and t denotes the thickness of the flash. The maximum thickness enabling the flash to break first during soldering is given in Figure 2b with the radius r of the vent hole as a parameter. For a given vent hole radius r, if the thickness value lies below the straight line in the region indicated by the arrow, cracks will occur in the flash portion 15a first, avoiding cracking of the more substantial parts of the package.

If the diameter 2r of the vent hole is 1.0 mm and the thickness of the flash 15a is 0.1 mm, swelling or cracking occurs with some sealing materials. but when the thickness h below the low-adhesion layer is around 0.85 mm the swelling or cracking does not occur, so a wider range of sealing materials is available for selection.

With the configuration described above, a heat-resistant, plastic-packaged semiconductor device using a flat package can be formed. The low-adhesion layer 17 in this example is a layer of gold plating, but

3

nickel (Ni), chromium (Cr), cobalt (Co) and other plating materials which impart passivity to the outer surface could also be used, or material could be used on the surface of which forms an oxide film imparting the desired passivity. Still alternatively, a fluoride resin such as polytetrafluoroethylene (Reg. Trade Mark: Teflon), silicone resin, or other substances having low adhesion to the moulding could be used.

The area covered by the low adhesion layer 17 can be the entirety of the undersurface of the island 12, or the part corresponding to the vent hole 18. Alternatively, the low-adhesion layer 17 can be extended to cover part or all of the island supports 11a to permit even easier escape of water vapour. A copper lead frame may be used instead of a 42-alloy lead frame, but still the low-adhesion layer 17 can be formed on it.

The vent hole 18 need not be circular: a polygonal shape can also be used. As long as the hole is small, its shape is unrestricted. For the chip coating 16, instead of the silicone resin given above, a polyimide resin can also be used. Although in the example described, a chip coating is provided to prevent penetration of impurity ions from the mould resin, the chip coating may be eliminated where a mould resin is used which does not contain corrosive impurities. Although a flat package was described above, this invention can also be applied to various other types of resin-sealed packages, e.g., with dual in-line pin (DIP or DIL) structures.

Results of high-temperature tests of heat-resistant plastic semiconductor devices embodying the invention are shown in the Table 1. The specimens tested had a 44-pin flat package with a flash thickness of $t = 0$ and 0.1 and a vent hole diameter of $2r = 1$ mm. They were allowed to absorb moisture of 72 hours under conditions of 85°C and 85% RH, and were heat-processed in an infrared reflow chamber at a temperature of 245°C on the package surface. The results are set out as a ratio of the number of cracked specimens over the total number tested.

## Table 1

| Low-adhesion layer | $t=0$ | $t=0.1$ |
|---|---|---|
| Au | 0/20 | 0/20 |
| Ni | 0/20 | 0/20 |
| Unplated | 4/20 | 7/20 |

As the Table 1 indicates, test results of this invention were favorable.

Because in this invention a low-adhesion layer is formed on at least part of the undersurface of the island and a vent hole is provided at the corresponding location in the bottom of the package as explained in the detailed description, during high-temperature processes such as soldering, vapour from absorbed moisture can escape to the outside via the interface between the low-adhesion layer and the moulding, and the vent hole. The result is a reduction in internal stress due to water vapour pressure, so that cracking of the package is avoided; and an improvement in the resistance of the device to heat.

Results of tests of humidity-resistance of heat-resistant plastic semiconductor devices according to the invention are shown in Table 2. The humidity resistance tests, referred to as pressure cooker tests, were conducted at a temperature of 121°C and at a relative humidity of 100% RH, and at 2 bar (2 atms) of pressure. The devices tested were of a 44 pin package having a flash thickness of $t = 0.1$ mm, a vent hole diameter $2r = 1$mm. Prior to this test, the devices were subjected to moist conditions at a temperature of 85°C and at a humidity of 85% RH for 72 hours, and then heated in an infrared reflow oven to produce a temperature on the surface of the package of 245°C. In the table 2, the 'PTC_____H' indicates the time (hours) the sample is subjected to the Pressure Cooker Test.

The failures which occured when there was no chip coating were contact failure due to Al corrosion at the bonding pads. The Table 2 indicates provision of the chip coating improves the humidity resistance, again the results being given as the number of cracked specimens over the total number tested.

## Table 2

| Low-adhesion layer | Without chip coating | | With chip coating | |
|---|---|---|---|---|
| | PCT 500H | PCT 1000H | PCT 500H | PCT 1000H |
| Au | 0/22 | 1/22 | 0/22 | 0/22 |
| Ni | 0/22 | 1/22 | 0/22 | 0/22 |
| Unplated | 1/22 | 3/21 | 0/22 | 0/22 |

The present invention thus yields a highly-reliable, heat-resistant plastic semiconductor device capable of high density mounting.

## Claims

1. A Semi-conductor device having an IC Chip (13) on one side of an island (12); external leads (11) connected to the IC Chip (13); bonding wires (14) for connecting the contacts of the IC Chip (13) and the inner ends of the external leads (11): a package (15) of moulded resin for encapsulating the IC Chip (13), the island (12), the bonding wires (14) and the inner ends of the external leads (11): and a vent aperture (18) extending through the package (15) to the side of the island (12) opposite to the IC Chip: CHARACTERISED IN THAT the side of the island (12) to which the aperture (18) extends has a low adhesion layer (17) that adheres only weakly to the resin of the package (15).

2. A device according to claim 1 further characterised in that the low adhesion layer (17) is of Au, Ni, Cr, Co, fluoride resin or silicone resin.

3. A device according to claim 1 or claim 2 further characterised in that the low adhesion layer (17) covers part or all of the side of the island (12) adjacent the vent aperture (18).

4. A device according to any of the preceding claims further characterised in that a thickness (15a) of resin remains between the inner extremity of the aperture (18) and the layer (17), which thickness is sufficiently small so that thickness (15a) breaks before the remainder of the package (15) after heat application to permit water to vent.

5. A device according to any of the preceding claims further characterised in that the vent aperture (18) is formed in part of the package (15) which covers the low-adhesion layer, preferably centrally of the island (12).

6. A device according to any of the preceding claims further characterised in that the aperture (18) is a hole extending generally vertically with respect to the island (12).

7. A device according to any of the preceding claims further characterised in that the package (15) comprises an epoxy resin.

8. A device according to any of the preceding claims further characterised in that a chip coating (16) capable at least of preventing penetration of corrosive impurity ions from the package (15) is provided between the IC chip (13) and adjacent parts of the package (15), the coating being preferably of silicone or polyimide resin.

9. A device according to claim 8 further characterised in that the chip coating (16) covers contact portions on the IC chip (13) and internal leads (14) interconnecting the contact portions and the external leads (11).

10. A device according to any of the preceding claims further characterised in that the external leads (11) and the island (12) are formed by a lead frame.

**Revendications**

1. Un dispositif semi-conducteur comportant une microplaquette de circuit intégré (ou IC) (13) sur un côté d'un îlot (12); des conducteurs extérieurs (11) reliés à la microplaquette IC (13); des fils de liaison (14) pour relier les contacts de la microplaquette IC (13) et les extrémités intérieures des conducteurs extérieurs (11); un boîtier (15) en résine moulée pour encapsuler la microplaquette IC (13), l'îlot (12), les fils de liaison (14) et les extrémités intérieures des conducteurs extérieurs (11); et une ouverture de mise à l'atmosphère (18) traversant le boîtier (15) sur le côté de l'îlot (12) opposé à la microplaquette IC; CARACTERISE EN CE QUE le côté de l'îlot (12) où s'étend l'ouverture (18) comporte une couche de faible adhérence (17) qui n'adhère que faiblement à la résine du boîtier (15).

2. Un dispositif selon la revendication 1 caractérisé en outre en ce que la couche (17) de faible adhérence est en Au, Ni, Cr, Co, en résine de fluorure ou en résine de silicone.

3. Un dispositif selon la revendication 1 ou la revendication 2 caractérisé en outre en ce que la couche à faible adhérence (17) couvre une partie ou la totalité du côté de l'îlot (12) adjacent à l'ouverture de mise à l'atmosphère (18).

4. Un dispositif selon l'une quelconque des revendications précédentes caractérisé en outre en ce qu'il reste, entre l'extrémité intérieure de l'ouverture (18) et la couche (17), une épaisseur (15a) de résine, qui est suffisamment faible pour que l'épaisseur (15a) se brise avant le reste du boîtier (15) après application de chaleur pour permettre à l'eau de s'évacuer à l'atmosphère.

5. Un dispositif selon l'une quelconque des revendications précédentes caractérisé en outre en ce que l'ouverture de mise à l'atmosphère (18) est formée dans une partie du boîtier (15) qui couvre la couche à faible adhérence, de préférence au centre de l'îlot (12).

6. Un dispositif selon l'une quelconque des précédentes revendications caractérisé en outre en ce que l'ouverture (18) est un trou s'étendant généralement verticalement par rapport à l'îlot (12).

7. Un dispositif selon l'une quelconque des revendications précédentes caractérisé en outre en ce que le boîtier (15) comprend une résine époxy.

8. Un dispositif selon l'une quelconque des revendications précédentes caractérisé en outre en ce qu'un revêtement (16) de microplaquette, susceptible au moins d'empêcher la pénétration d'ions d'impuretés corrosives à partir du boîtier (15) est disposé entre la microplaquette IC (13) et des parties adjacentes du boîtier (15), le revêtement étant de préférence en silicone ou en résine de polyimide.

9. Un dispositif selon la revendication 8 caractérisé en outre en ce que le revêtement (16) de microplaquette couvre des parties de contact sur la microplaquette IC (13) et les conducteurs intérieurs (14) reliant entre eux les parties de contact et les conducteurs extérieurs (11).

10. Un dispositif selon l'une quelconque des revendications précédentes caractérisé en outre en ce que les conducteurs extérieurs (11) et l'îlot (12) sont constitués par un cadre de conducteurs ou lead frame.

**Ansprüche**

1. Halbleiterbauelement mit einem IC-Chip (13) auf einer Seite eines inselartigen Trägers (12); externen Zuführungsdrähten (11), die an den IC-Chip (13) angeschlossen sind; Verbindungsdrähten (14) zur Verbindung der Kontakte des IC-Chips (13) mit den inneren Enden der externen Zuführungsdrähte (11); einer Umhüllung (15) aus gegossenem Harz zur Verkapselung des IC-Chips (13), des inselartigen Trägers (12), der Verbindungsdrähte (14) und der inneren Enden der externen Zuführungsdrähte (11); und einer Belüftungsöffnung (18), die sich durch die Umhüllung (15) hindurch zu der dem IC-Chip entgegengesetzten Seite des inselartigen Trägers (12) hin erstreckt; dadurch gekennzeichnet, daß die Seite des inselartigen Trägers (12), zu der sich die Öffnung (18) hin erstreckt, eine Schicht mit geringer Haftung (17) hat, die nur schwach am Harz der Umhüllung (15) haftet.

2. Bauelement nach Anspruch 1, weiterhin dadurch gekennzeichnet, daß die Schicht mit geringer Haftung (17) aus Au, Ni, Cr, Co, Fluoridharz oder Silikonharz ist.

3. Bauelement nach Anspruch 1 oder Anspruch 2, weiterhin dadurch gekennzeichnet, daß die Schicht mit geringer Haftung (17) einen Teil oder das Ganze der an die Belüftungsöffnung (18) angrenzenden Seite des inselartigen Trägers (12) bedeckt.

4. Bauelement nach einem der vorhergehenden Ansprüche, weiterhin dadurch gekennzeichnet, daß eine Lage (15a) Harz zwischen dem inneren Ende der Öffnung (18) und der Schicht (17) bestehen bleibt, die ausreichend dünn ist, so daß sie nach der Einwirkung von Wärme vor dem Rest der Umhüllung (15) bricht, damit Wasser entweichen kann.

5. Bauelement nach einem der vorhergehenden Ansprüche, weiterhin dadurch gekennzeichnet, daß die Belüftungsöffnung (18) in einem Teil der Umhüllung (15) ausgebildet ist, der die Schicht mit geringer Haftung bedeckt, vorzugsweise in der Mitte des inselartigen Trägers (12).

6. Bauelement nach einem der vorhergehenden Ansprüche, weiterhin dadurch gekennzeichnet, daß die Öffnung (18) ein Loch ist, das sich im allgemeinen senkrecht zum inselartigen Träger (12) erstreckt.

7. Bauelement nach einem der vorhergehenden Ansprüche, weiterhin dadurch gekennzeichnet, daß die Umhüllung (15) ein Epoxidharz aufweist.

8. Bauelement nach einem der vorhergehenden Ansprüche, weiterhin dadurch gekennzeichnet, daß zwischen dem IC-Chip (13) und daran angrenzenden Teilen der Umhüllung (15) ein Chip-Überzug (16) vorgesehen ist, der zumindest ein Eindringen von korrodierenden Verunreinigungsionen aus der Umhüllung (15) verhindern kann, wobei der Überzug vorzugsweise aus Silikon- oder Polyimidharz ist.

9. Bauelement nach Anspruch 8, weiterhin dadurch gekennzeichnet, daß der Chip-Überzug (16) Kontaktabschnitte auf dem IC-Chip (13) und interne Verbindungsdrähte (14), die die Kontaktabschnitte und die externen Zuführungsdrähte (11) miteinander verbinden, bedeckt.

10. Bauelement nach einem der vorhergehenden Ansprüche, weiterhin dadurch gekennzeichnet, daß die externen Zuführungsdrähte (11) und der inselartige Träger (12) durch eine Leiterplatte gebildet werden.

# FIG.1a

# FIG.1b

# FIG.2a

# FIG.2b

# FIG.3

22,23

B

B

25    21

# FIG.4a

24    25

21

22    23

# FIG.4b

24  26  25

21

22  23

# FIG.5

# FIG.6a

# FIG.6b

# FIG.7a

# FIG.7b

# FIG.7c